# FASCICULE DE BREVET EUROPEEN

(11) **EP 0 661 806 B1**
(45) Date de publication et mention de la délivrance du brevet: **20.10.1999**
(21) Numéro de dépôt: 94410112.0
(22) Date de dépôt: 29.12.1994
(51) Int. Cl.: H03H 11/48

(54) **Capacité commandée en tension**
Spannungsgesteuerte Kapazität
Voltage controlled capacitance

(30) Priorité: 30.12.1993 FR 9316032
(43) Date de publication de la demande: 05.07.1995
(73) Titulaire: STMicroelectronics S.A., 94250 Gentilly (FR)
(72) Inventeur: Kodrnja, Marc, F-38100 Grenoble (FR); Dufossez, Vincent, F-38000 Grenoble (FR)
(74) Mandataire: de Beaumont, Michel

(56) Documents cités:
- WO-A-86/07508
- US-A- 3 702 405
- US-A- 5 166 560

## Description

La présente invention concerne les oscillateurs sinusoïdaux commandés en tension, et plus particulièrement une capacité commandée en tension utilisée dans de tels oscillateurs.

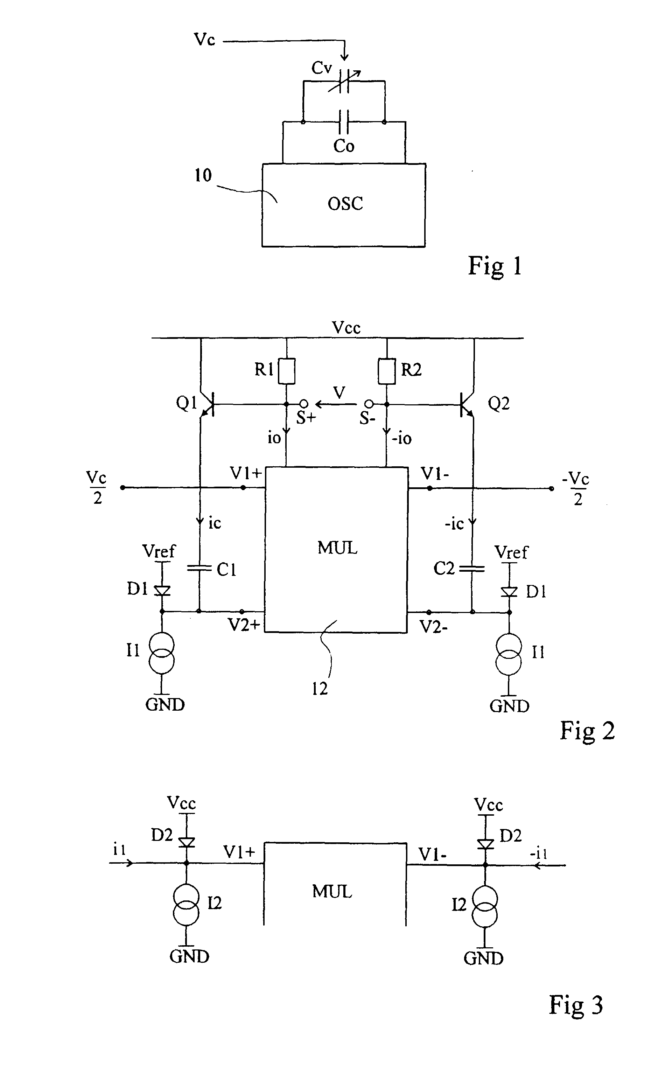

La figure 1 représente schématiquement un oscillateur sinusoïdal commandé en tension classique 10, du type à capacité commandée en tension. Un tel oscillateur comprend généralement une capacité fixe Co sur laquelle est reliée en parallèle une capacité Cv dont la valeur dépend d'une tension Vc. La fréquence d'oscillation de l'oscillateur est déterminée par la somme des valeurs des capacités Co et Cv. La tension Vc, qui agit sur la valeur de la capacité Cv, agit également sur la fréquence de l'oscillateur.

Généralement, la capacité Cv est constituée par une diode dite "varicap", qui est une diode dont la capacité de jonction dépend de la tension de polarisation de la diode. Toutefois, une telle capacité variable présente l'inconvénient d'être fortement dépendante de la température.

La demande de brevet PCT/WO86/07508 décrit une capacité commandée en tension formée à l'aide d'un circuit comprenant deux capacités de référence associées à deux étages différentiels croisés. La tension de sortie de chaque étage est appliqué sur une borne de la capacité associée à l'étage et l'autre borne de la capacité est connectée aux émetteurs du transistor de l'étage. Pour augmenter la fréquence limite de fonctionnement, il est prévu des résistances de compensation qui coopèrent avec les capacités de référence.

Toutefois, il est difficile d'apparier une capacité et une résistance dans un circuit intégré notamment si la technologie de fabrication du circuit intégré est modifiée. En outre, une capacité et une résistance ne varient pas de la même manière en fonction de la température. Il en résulte que la fréquence limite de la capacité commandée varie dans des proportions relativement importantes en fonction de la technologie et de la température.

Un objet de la présente invention est de prévoir une capacité variable de grande stabilité en température et qui puisse être utilisée à des fréquences élevées.

Cet objet est atteint grâce à une capacité commandée en tension, comprenant un multiplieur dont la sortie joue le rôle des bornes de la capacité commandée. La tension de sortie du multiplieur est appliquée sur une capacité de référence. Un signal en phase avec le courant dans la capacité de référence est appliqué à l'une des entrées du multiplieur, l'autre entrée du multiplieur recevant un signal de détermination de la valeur de la capacité commandée.

Selon un mode de réalisation de la présente invention, la capacité commandée en tension comprend deux paires différentielles parallèles commandées de manière croisée par un premier signal différentiel. Les deux branches de sortie de ces paires différentielles constituent les bornes de la capacité commandée. Deux transistors de polarisation sont connectés pour déterminer les courants de polarisation respectifs des deux paires différentielles en fonction d'un deuxième signal différentiel. Les tensions respectives des bornes de la capacité commandée sont appliquées sur deux capacités de référence respectives. Les courants respectifs dans les capacités de référence sont fournis en tant que premier ou deuxième signal différentiel. Deux transistors de compensation ont leurs émetteurs reliés par l'intermédiaire d'une capacité de compensation et ils sont reliés en parallèle par leurs collecteurs et par leurs bases sur respectivement les deux transistors d'une paire différentielle ou les deux transistors de polarisation.

Selon un mode de réalisation de la présente invention, une première borne de chaque capacité de référence est reliée à la sortie associée du multiplieur par l'intermédiaire d'un transistor monté en suiveur, et la deuxième borne de chaque capacité de référence est reliée à une borne d'entrée associée du multiplieur, cette borne d'entrée étant reliée à une tension de référence par l'intermédiaire d'une diode montée dans le sens passant et à une tension basse par l'intermédiaire d'une source de courant.

Ces objets, caractéristiques et avantages ainsi que d'autres de la présente invention seront exposés en détail dans la description suivante de modes de réalisation particuliers faite à titre non-limitatif à l'aide des figures jointes parmi lesquelles :
la figure 1, précédemment décrite, représente schématiquement un oscillateur commandé en tension classique ;
la figure 2 représente un mode de réalisation de capacité variable réalisée à l'aide d'un circuit multiplieur ;
la figure 3 représente un montage permettant, à l'aide du circuit de la figure 2, d'obtenir une capacité proportionnelle à un signal de commande ;
la figure 4A représente un mode de réalisation détaillé de capacité variable à circuit multiplieur, associée à un mode de réalisation de circuit de compensation selon l'invention ; et
la figure 4B représente un diagramme de phase illustrant le fonctionnant du circuit de compensation de la figure 4A.

La figure 2 représente un mode de réalisation de capacité commandée en tension, utilisant un circuit multiplieur 12, tel qu'un multiplieur de Gilbert.

Un multiplieur de Gilbert est décrit dans "Analysis and Design of Analog Integrated Circuits", 3ème édition, Paul R. Gray, Robert G. Meyer, Edition John Wiley & Sons, Inc.

Un multiplieur de Gilbert, 12, comprend deux entrées différentielles V1+/V1- et V2+/V2-, respectivement, et une sortie différentielle de courant S+/S-. Le courant de sortie est sensiblement proportionnel au produit des deux tensions d'entrée (V1 entre les bornes V1+ et V1- et V2 entre les bornes V2+ et V2-) lorsque ces tensions d'entrée V1 et V2 varient au voisinage de zéro.

La tension Vc permettant de déterminer la valeur de la capacité commandée est appliquée entre les bornes V1+ et V1-.

Les bornes S+ et S- sont reliées à un potentiel haut Vcc par des résistances respectives R1 et R2 de même valeur. Les tensions sur les bornes S+ et S- sont recopiées sur des premières bornes de capacités respectives C1 et C2 de même valeur par l'intermédiaire de transistors NPN Q1 et Q2 montés en émetteurs suiveurs. Les émetteurs de ces transistors sont reliés aux capacités C1 et C2, les bases aux sorties S+ et S-, et les collecteurs au potentiel Vcc. Les bornes restantes des capacités C1 et C2 sont reliées aux bornes d'entrée V2+ et V2- respectivement. Les bornes V2+ et V2- sont en outre reliées à des montages de linéarisation respectifs comprenant chacun une diode D1 reliant la borne d'entrée à une tension de référence constante Vref dans le sens passant et une source de courant I1 reliant la borne d'entrée à un potentiel bas GND. Chacune des diodes D1 est constituée, par exemple, par un transistor NPN dont la base est reliée à la tension Vref, le collecteur au potentiel Vcc et l'émetteur à la source de courant I1 associée.

On suppose maintenant que l'on applique une tension alternative V entre les bornes S+ et S- de sortie du multiplieur 12. Il apparait alors sur l'émetteur du transistor Q1 une tension alternative V/2, et sur l'émetteur du transistor Q2 une tension alternative -V/2. Ces tensions V/2 et -V/2 entraînent un courant alternatif ic dans la capacité C1 et -ic dans la capacité C2. Grâce aux montages de linéarisation Dl/Il, les composantes alternatives des courants de sortie du multiplieur 12, io sur la borne S+ et -io sur la borne S-, sont proportionnelles aux courants ic et -ic. Ainsi, les courants dans les capacités C1 et C2 sont recopiés, à un facteur multiplicatif prés, sur les sorties S+ et S-. Il en résulte que le circuit se comporte, entre les bornes S+ et S-, comme une capacité proportionnelle aux capacités C1 et C2. En outre, le coefficient de proportionnalité dépend lui-même de la tension de commande Vc appliquée entre les bornes V1+ et V1-. De façon plus précise, ce coefficient de proportionnalité varie selon une tangente hyperbolique de la tension de commande Vc, entre une limite inférieure -A et une limite supérieure A lorsque la tension de commande Vc tend vers moins l'infini et l'infini, respectivement. En pratique, la limite -A ou A est atteinte lorsque la tension Vc devient grande, en valeur absolue, par rapport à 2kT/q, où k est la constante de Boltzmann, T la température absolue, et q la charge d'un électron. La constante A est déterminée par la structure du multiplieur 12.

Avec le circuit de la figure 2, on obtient une capacité variable commandée en tension pouvant avoir une valeur nulle et même négative (pour une tension de commande Vc nulle ou négative). Ceci simplifie la commande d'un oscillateur qui utilise la capacité commandée.

En outre, les capacités de référence C1 et C2, fixes, ont l'avantage d'être particulièrement stables en température, notamment en technologie intégrée, par rapport à la capacité d'une diode varicap.

La figure 3 représente une variante du circuit de la figure 2 permettant d'obtenir une capacité variable proportionnelle à un signal de commande. Pour cela, on place sur les bornes d'entrée V1+ et V1- des montages de linéarisation à diodes D2 et sources de courant I2 de la même manière que pour les bornes d'entrée V2+ et V2- de la figure 2. Les diodes D2 sont reliées à un potentiel compris entre Vref et Vcc, par exemple au potentiel Vcc. Avec cette configuration, la capacité commandée est proportionnelle à un courant de commande différentiel il, -il circulant entre les bornes V1+ et V1-.

La capacité commandée de la figure 2 peut fonctionner à des fréquences relativement élevées. Toutefois, divers phénomènes parasites, tels que les résistances série des capacités C1 et C2, les résistances base-émetteur des transistors Q1, Q2, les déphasages introduits par les transistors, limitent la fréquence maximale de fonctionnement.

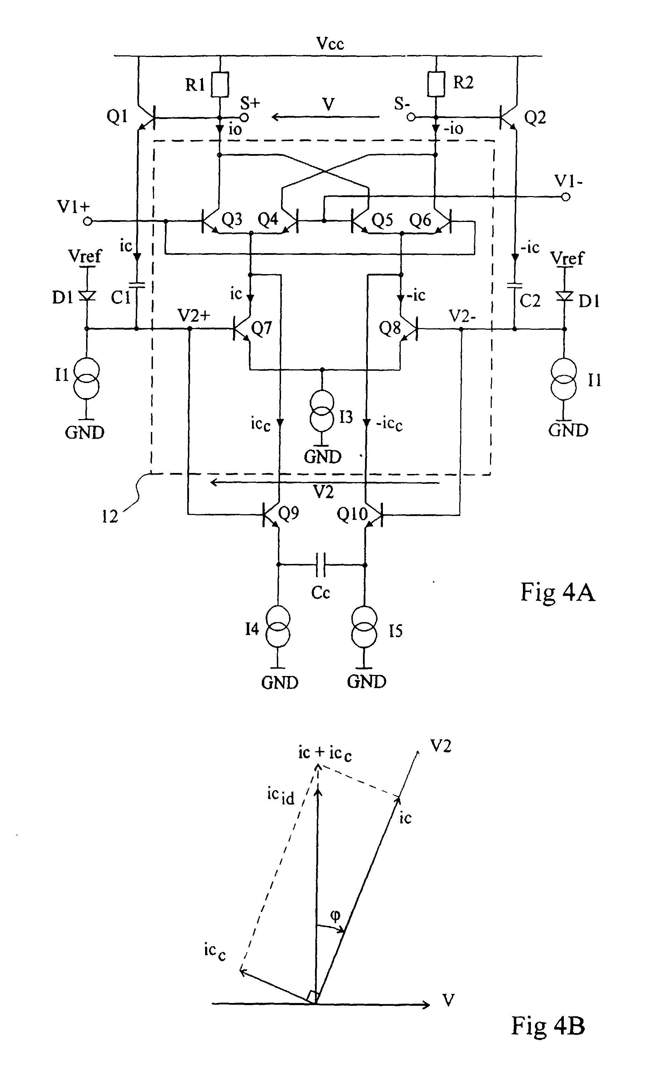

La figure 4A représente le circuit de la figure 2 plus en détail, associé à un mode de réalisation de dispositif de compensation selon l'invention permettant d'augmenter la limite de la fréquence de fonctionnement de la capacité commandée. Cette figure représente notamment un mode de réalisation détaillé d'un multiplieur de Gilbert 12.

Le multiplieur 12 comprend deux paires différentielles formées par des transistors NPN Q3, Q4 et Q5, Q6, dont les branches de sortie sont connectées en parallèle sur les bornes de sortie S+ et S-. Les paires différentielles Q3/Q4 et Q5/Q6 sont commandées de façon croisée par les bornes d'entrée V1+ et V1-, c'est-à-dire que la borne V1+ commande, dans la première paire différentielle, le transistor Q3 relié à la borne de sortie S+ et, dans la deuxième paire différentielle, le transistor Q6 relié à la borne de sortie S-, et que la borne d'entrée V1-commande, dans la première paire différentielle, le transistor Q4 relié à la borne S- et, dans la deuxième paire différentielle, le transistor Q5 relié à la borne S+.

Les courants de polarisation des paires différentielles Q3/Q4 et Q5/Q6 sont fixés par les branches respectives d'une paire différentielle formée de transistors NPN Q7 et Q8. La base du transistor Q7 est commandée par la borne d'entrée V2+ et la base du transistor Q8 est commandée par la borne d'entrée V2-. Le courant de polarisation de la paire différentielle Q7/Q8 est déterminé par une source de courant I3 reliée au potentiel GND.

Avec un tel multiplieur, les courants de polarisation des paires différentielles Q3/Q4 et Q5/Q6 sont déterminés par la tension V2 entre les bornes V2+ et V2-. Les paires différentielles Q3/Q4 et Q5/Q6 amplifient la tension entre les bornes V1+ et V1-, mais le coefficient d'amplification dépend justement des courants de polarisation de ces paires différentielles. Il en résulte un effet de multiplication entre les tensions présentes sur les bornes V1+, V1- et sur les bornes V2+, V2-. Une description plus détaillée du fonctionnement du multiplieur 12 peut être trouvée dans tout ouvrage traitant de multiplieurs de Gilbert.

Bien entendu, les rôles des deux entrées du multiplieur (V1+/V1- et V2+/V2-) peuvent être intervertis. Les capacités C1 et C2 ainsi que les montages de linéarisation D1/I1 sont alors reliés aux bornes V1+ et V1-, la tension de commande Vc étant appliquée entre les bornes V2+ et V2-. On veillera toutefois à ce que la tension de mode commun sur l'entrée V1+/V1- soit supérieure à la tension de mode commun sur l'entrée V2+/V2-.

La présente invention prévoit un système de compensation, décrit ci-après, qui permet à la capacité commandée de la figure 4A de fonctionner à des fréquences particulièrement élevées, par exemple de l'ordre de 40 mégahertz avec les technologies de fabrication actuelles.

Ce système de compensation comprend, dans l'exemple de la figure 4A, un transistor NPN Q9 relié en parallèle par son collecteur et sa base sur le transistor Q7 et un transistor NPN Q10 relié en parallèle par son collecteur et sa base sur le transistor Q8. Les émetteurs des transistors Q9 et Q10 sont reliés l'un à l'autre par une capacité de compensation Cc et au potentiel GND par des sources de courant respectives I4 et I5.

La figure 4B représente un diagramme de déphasage illustrant le fonctionnement du système de compensation de la figure 4A. Quand une tension alternative V est appliquée entre les bornes de sortie S+ et S- du multiplieur, il apparaît, comme on l'a précédemment indiqué, un courant ic dans la capacité C1 et un courant -ic dans la capacité C2. Les montages de linéarisation Dl/Il associés aux transistors Q7 et Q8 agissent de telle manière que les courants ic et -ic sont superposés sur les courants de repos des collecteurs des transistors Q7 et Q8. Le courant ic et la tension V2 apparaissant entre les bornes V2+ et V2- sont en phase, ce qui est représenté dans le diagramme de la figure 4B. Toutefois, le courant ic réel est déphasé d'une valeur ϕ par rapport au courant ic idéal ic_{id} par des phénomènes parasites. Ce déphasage ϕ augmente avec la fréquence de fonctionnement de la capacité commandée et empêche un bon fonctionnement au-delà d'une fréquence limite.

A l'aide du système de correction selon l'invention, la tension V2, alternative, est appliquée aux bornes de la capacité de compensation Cc par les transistors Q9 et Q10, ce qui crée dans cette capacité Cc un courant ic_{c} déphasé de 90° par rapport au courant ic et la tension V2. Les transistors Q9 et Q10 ajoutent, par leurs collecteurs, un courant ic_{c} au courant de collecteur du transistor Q7 et un courant -ic_{c} au courant de collecteur du transistor Q8. Ainsi, les courants utiles, c'est-à-dire les composantes alternatives des courants de polarisation des paires différentielles Q3/Q4 et Q5/Q6, s'établissent à des valeurs ic+ic_{c} et -ic-ic_{c} de phase très proche de celle du courant ic idéal. L'amplitude du courant ic_{c} est déterminée par la valeur de la capacité Cc. Ainsi, pour obtenir une compensation optimale, c'est-à-dire obtenir un courant ic+ic_{c} en phase avec le courant ic idéal il suffit de choisir de façon adéquate, éventuellement par essais, la valeur de la capacité Cc en fonction de la fréquence nominale de fonctionnement de la capacité commandée.

Si les rôles des deux entrées V1+/V1- et V2+/V2- sont intervertis, le transistor de compensation Q9 est relié en parallèle par sa base et son collecteur sur l'un des transistors Q3 et Q6, et le transistor de compensation Q10 est relié en parallèle par sa base et son collecteur sur l'un des transistors Q4 et Q5.

Le système de compensation selon l'invention a été décrit en relation avec un multiplieur de Gilbert, mais il s'applique à tout système multiplieur où un étage d'amplification d'un premier signal à multiplier est polarisé par un courant déterminé par un deuxième signal à multiplier.

## Revendications

1. Capacité commandée en tension, caractérisée en ce qu'elle comprend :
- deux paires différentielles parallèles (Q3/Q4, Q5/Q6) commandées de manière croisée par un premier signal différentiel (V1+/V1-), les deux branches de sortie de ces paires différentielles constituant les bornes (S+/S-) de la capacité commandée ;
- deux transistors de polarisation (Q7, Q8) connectés pour déterminer les courants de polarisation respectifs des deux paires différentielles en fonction d'un deuxième signal différentiel (V2+/V2-) ;
- des moyens (Q1, Q2) pour appliquer les tensions respectives des bornes de la capacité commandée sur deux capacités de référence respectives (C1, C2) ;
- des moyens pour fournir, en tant que premier ou deuxième signal différentiel, les courants respectifs dans les capacités de référence ; et
- deux transistors de compensation (Q9, Q10) ayant des premières électrodes principales reliées par l'intermédiaire d'une capacité de compensation (Cc) et reliés en parallèle par leurs deuxièmes électrodes principales et par leurs électrodes de commande sur respectivement les deux transistors d'une paire différentielle ou les deux transistors de polarisation.

2. Capacité commandée selon la revendication 1, caractérisée en ce qu'une première borne de chaque capacité de référen (C1, C2) est reliée à la sortie associée du multiplieur (S+, S-) par l'intermédiaire d'un transistor (Q1, Q2) monté en suiveur, et en ce que la deuxième borne de chaque capacité de référence est reliée à une borne d'entrée (V2+, V2-) associée du multiplieur, cette borne d'entrée étant reliée à une tension de référence (Vref) par l'intermédiaire d'une diode (D1) montée dans le sens passant et à une tension basse par l'intermédiaire d'une source de courant (I1).

3. Capacité commandée selon la revendication 2, caractérisée en ce que les transistors de polarisation (Q7, Q8) sont montés en paire différentielle.

## Patentansprüche

1. Spannungsgesteuerte Kapazität, dadurch gekennzeichnet, daß sie umfaßt:
- zwei in gekreuzter Weise durch ein erstes Differenzsignal (V1+/V1-) gesteuerte parallele Differenzpaare (Q3/Q4, Q5/Q6), wobei die beiden Ausgangszweige dieser Differenzpaare die Anschlüsse (S+/S-) der gesteuerten Kapazität darstellen;
- zwei Vorspannungstransistoren (Q7,Q8) in solcher Schaltung, daß sie die entsprechenden Vorspannströme der beiden Differenzpaare in Abhängigkeit von einem zweiten Differenzsignal (V2+/V2-) bestimmen;
- Mittel (Q1,Q2) zum Anlegen der entsprechenden Spannungen der Anschlüsse der gesteuerten Kapazität an zwei entsprechende Bezugskapazitäten (C1,C2);
- Mittel, welche die entsprechenden Ströme in den Bezugskapazitäten als erstes oder zweites Differenzsignal liefern; sowie
- zwei Kompensationstransistoren (Q9,Q10) mit ersten Hauptelektroden, die mittels einer Kompensationskapazität (Cc) miteinander verbunden sind und die mit ihren zweiten Hauptelektroden und ihren Steuerelektroden entsprechend parallel über den beiden Transistoren eines Differenzpaars oder über den beiden Vorspanntransistoren liegen.

2. Gesteuerte Kapazität nach Anspruch 1, dadurch gekennzeichnet, daß ein erster Anschluß jeder Bezugskapazität (C1,C2) jeweils mit dem zugeordneten Ausgang der Multipliziervorrichtung (S+,S-) über einen als Folger geschalteten Transistor (Q1,Q2) verbunden ist, und daß der zweite Anschluß jeder Bezugskapazität jeweils mit einem zugeordneten Eingangsanschluß (V2+,V2-) der Multipliziervorrichtung verbunden ist, wobei dieser Eingangsanschluß mit einer Bezugsspannung (Vref) über eine in Durchlaßrichtung angeordnete Diode (D1) und über eine Stromquelle (I1) mit einer niedrigen Spannung verbunden ist.

3. Gesteuerte Kapazität nach Anspruch 2, dadurch gekennzeichnet, daß die Vorspanntransistoren (Q7,Q8) als Differenzpaar geschaltet sind.

## Claims

1. A voltage-controlled capacitor, characterized in that it includes:
- two parallel differential pairs (Q3/Q4, Q5/Q6) cross-controlled by a first differential signal (V1+/V1-), the two output branches of said differential pairs constituting the terminals (S+/S-) of the controlled capacitor;
- two biasing transistors (Q7, Q8) connected to determine the respective bias currents of the two differential pairs as a function of a second differential signal (V2+/V2-) ;
- means (Q1, Q2) for applying the respective voltages of the controlled capacitor terminals to two respective reference capacitors (C1, C2);
- means for providing, as said first or second differential signal, the respective currents in the reference capacitors; and
- two compensation transistors (Q9, Q10) having first main electrodes connected together by a compensation capacitor (Cc) and being connected in parallel by their second main electrodes and their control electrodes respectively to the two transistors of one of the differential pairs or to the two biasing transistors.

2. The voltage-controlled capacitor of claim 1, wherein a first terminal of each reference capacitor (C1, C2) is connected to the associated multiplier output (S+, S-) through an emitter-follower transistor (Q1, Q2), and wherein the second terminal of each reference capacitor is connected to an associated input terminal (V2+, V2-) of the multiplier, said input terminal being connected to a reference voltage (Vref) through a diode (D1) biased by a current source (I1).

3. The voltage-controlled capacitor of claim 2, wherein the biasing transistors (Q7, Q8) are connected as a differential pair.
